# EUROPEAN PATENT APPLICATION

(11) **EP 4 742 865 A1**
(43) Date of publication of application: **13.05.2026**
(21) Application number: 24894439.9
(22) Date of filing: 31.10.2024
(51) Int. Cl.: H10H 20/857, H10H 20/84, H10H 20/831, H01L 25/075

(54) **LIGHT-EMITTING DIODE AND DISPLAY MODULE COMPRISING SAME**

(30) Priority: 20.11.2023 KR 20230161050
(71) Applicant: Samsung Electronics Co., Ltd., Suwon-si, Gyeonggi-do 16677 (KR)
(72) Inventor: PARK, Youngmok, Suwon-si, Gyeonggi-do 16677 (KR); JUNG, Jonghoon, Suwon-si, Gyeonggi-do 16677 (KR); HONG, Soonmin, Suwon-si, Gyeonggi-do 16677 (KR)
(74) Representative: Appleyard Lees IP LLP
(86) International application number: PCT/KR2024/016903
(87) International publication number: WO 2025/110545

(57) **Abstract**

A light-emitting diode and a display module comprising same are disclosed. The disclosed light-emitting diode comprises: a first semiconductor layer; a second semiconductor layer; an active layer provided between the first semiconductor layer and the second semiconductor layer so as to emit light; a first contact electrode electrically connected to the first semiconductor layer; a second contact electrode electrically connected to the second semiconductor layer; and a plurality of conductive members provided on the first contact electrode and the second contact electrode, wherein each of the plurality of conductive members includes a conductive adhesive member and a first protective layer that covers the conductive adhesive member.

## Description

### [Technical Field]

The disclosure relates to light-emitting diodes and a display module including the same.

### [Background Art]

A display panel includes a TFT substrate including a plurality of thin film transistors (TFTs) and a plurality of light-emitting diodes mounted on the substrate. The plurality of light-emitting diodes express various colors as they operate in pixel or subpixel units. Operations of each pixel or subpixel are controlled by the plurality of TFTs. Each light-emitting diode emits various colors, e.g., a red color, a green color, and a blue color. The plurality of light-emitting diodes may be transferred to the TFT substrate from a wafer or a relay substrate by a pick-and-place transfer method, a stamping transfer method, or a laser transfer method. The plurality of light-emitting diodes are electrically connected to substrate pads provided on the substrate by using a solder ball or an anisotropic conductive film (ACF), or a conductive adhesive.

### [Disclosure of Invention]

### [Solution to Problem]

A light-emitting diode according to an embodiment of the disclosure may include a first semiconductor layer, a second semiconductor layer, an active layer provided between the first semiconductor layer and the second semiconductor layer and configured to emit light, a first contact electrode electrically connected with the second semiconductor layer, a second contact electrode electrically connected with the first semiconductor layer, and a plurality of conductive members provided on the first contact electrode and the second contact electrode. The plurality of conductive members may include a conductive adhesive member, and a protective layer that covers the conductive adhesive member.

The protective layer may be a first protective layer. The plurality of conductive members may further respectively include a second protective layer that covers the first protective layer.

A light-emitting diode according to an embodiment may further include a partition between the first contact electrode and the second contact electrode and includes an insulating material.

The plurality of conductive members may be arranged on the first contact electrode and the second contact electrode at intervals.

The plurality of conductive members may be arranged on the first contact electrode and the second contact electrode in specific patterns.

The plurality of conductive members may have a polygonal shape, a circular shape, or an oval shape when the light-emitting diode is viewed from a bottom surface.

A curing temperature of the conductive adhesive member may be lower than 200°C.

A range of a resistance value after curing of the conductive adhesive member may be from 0.1 ohm to 20 ohm.

The conductive adhesive member may include an epoxy resin, and conductive materials dispersed on the epoxy resin at intervals. The intervals between the conductive materials may narrow when the light-emitting diode is thermally pressed to the substrate. The conductive materials may contact each other or may be clumped. The conductive materials may make electric currents flow between the first contact electrode and a first substrate pad of the substrate and between the second contact electrode and a second substrate pad of the substrate.

Areas of each of the conductive adhesive members may be from 1% to 30% of smaller areas between the areas of the first contact electrode and the second contact electrode and the areas of the first substate pad and the second substrate pad.

The light-emitting diode is one of a plurality of light-emitting diodes. The plurality of light-emitting diodes may be constituted in forms of flip chips.

A method of manufacturing a light-emitting diode according to an embodiment may include the steps of patterning a plurality of conductive adhesive members on a first contact electrode and a second contact electrode of the light-emitting diode formed on a wafer, and forming a plurality of protective layers so as to cover the plurality of conductive adhesive members, respectively.

The method of manufacturing a light-emitting diode according to an embodiment may further include the step of forming a partition including an insulating material between the first contact electrode and the second contact electrode of the light-emitting diode.

The method of manufacturing a light-emitting diode according to an embodiment may further include the step of forming a plurality of second protective layers so as to cover the plurality of protective layers.

A display module according to an embodiment may include a substrate having a surface. A plurality of substrate pads are arranged on the surface of the substrate. A plurality of light-emitting diodes include a plurality of contact electrodes that are connected to the plurality of substrate pads.

Each of the plurality of light-emitting diodes may include a conductive connection member that electrically and physically connects the plurality of substrate pads and the plurality of contact electrodes. A plurality of walls between the plurality of contact electrodes may insulate the plurality of contact electrodes.

### Brief Description of Drawings

FIG. 1 is a diagram illustrating a display module according to an embodiment;
FIG. 2 is a cross-sectional view illustrating a part of a display module according to an embodiment;
FIG. 3 is a cross-sectional view illustrating a light-emitting diode provided to a display module according to an embodiment;
FIG. 4 is a bottom view illustrating a light-emitting diode provided to a display module according to an embodiment;
FIG. 5A and FIG. 5B are diagrams illustrating examples wherein a conductive adhesive member provided on a light-emitting diode was modified from a state wherein electric currents cannot flow to a state wherein electric currents can flow by thermal compression according to an embodiment;
FIG. 6, 7, and 8 are bottom views illustrating a light-emitting diode according to an embodiment;
FIG. 9 is a flow chart illustrating a manufacturing process of a light-emitting diode according to an embodiment;
FIG. 10 is a diagram illustrating an example wherein a light-emitting diode grew on a wafer according to an embodiment;
FIG. 11 is a diagram illustrating an example of patterning a conductive member on a contact electrode of a light-emitting diode according to an embodiment;
FIG. 12 is a diagram illustrating an example of irradiating ultraviolet (UV) on a first photoresist (PR) layer applied on a light-emitting diode through an opening of a first mask according to an embodiment;
FIG. 13 is a diagram illustrating an example wherein a part of a first PR layer corresponding to a plurality of conductive adhesive members provided to a light-emitting diode was cured according to an embodiment;
FIG. 14 is a diagram illustrating an example wherein a plurality of first protective layers covering a plurality of conductive adhesive members provided to a light-emitting diode were formed according to an embodiment;
FIG. 15 is a diagram illustrating an example of irradiating UV on a second PR layer applied on a light-emitting diode through an opening of a second mask according to an embodiment;
FIG. 16 is a diagram illustrating an example wherein a part of a second PR layer corresponding to a first protective layer provided to a light-emitting diode was cured according to an embodiment;
FIG. 17 is a diagram illustrating an example wherein a second protective layer covering a first protective layer provided to a light-emitting diode was formed according to an embodiment;
FIG. 18 is a diagram illustrating an example of irradiating UV on a third PR layer applied on a light-emitting diode through an opening of a third mask according to an embodiment;
FIG. 19 is a diagram illustrating an example wherein a part of a third PR layer corresponding to between a first contact electrode and a second contact electrode of a light-emitting diode was cured according to an embodiment;
FIG. 20 is a diagram illustrating an example wherein a partition was formed between a first contact electrode and a second contact electrode of a light-emitting diode according to an embodiment;
FIG. 21 is a flow chart illustrating a manufacturing process of a display module according to an embodiment;
FIG. 22 is a diagram illustrating an example wherein a first contact electrode and a second contact electrode were provided to each of a plurality of light-emitting diodes formed on a wafer according to an embodiment;
FIG. 23 is an enlarged view that illustrates in detail the light-emitting diode illustrated in FIG. 22 according to an embodiment;
FIG. 24 is a diagram illustrating an example of transferring a plurality of light-emitting diodes from a wafer to a first carrier substrate according to an embodiment;
FIG. 25 is a diagram illustrating an example of washing a first adhesive on a first carrier substrate;
FIG. 26 is an enlarged view that illustrates in detail the light-emitting diode illustrated in FIG. 25 according to an embodiment;
FIG. 27 is a diagram illustrating an example of transferring a plurality of light-emitting diodes from a first carrier substrate to a second carrier substrate according to an embodiment;
FIG. 28 is a diagram illustrating an example of washing a second adhesive on a second carrier substrate;
FIG. 29 is an enlarged view that illustrates in detail the light-emitting diode illustrated in FIG. 28 according to an embodiment;
FIG. 30 is a diagram illustrating an example of transferring a plurality of light-emitting diodes from a second carrier substrate to a substrate according to an embodiment;
FIG. 31 is a diagram illustrating an example of thermally compressing a plurality of light-emitting diodes to a substrate according to an embodiment; and
FIG. 32 is a block diagram illustrating a display device according to an embodiment.

### [Mode for Invention]

Hereinafter, various embodiments will be described in more detail with reference to the accompanying drawings. The embodiments described in this specification may be modified in various forms. Also, specific embodiments may be illustrated in the drawings, and explained in detail in the detailed description. However, the specific embodiments described in the accompanying drawings are just for making the various embodiments understood easily. Accordingly, the technical idea of the disclosure is not limited by the specific embodiments described in the accompanying drawings, but they should be interpreted to include all equivalents or alternatives included in the ideas and the technical scope of the disclosure.

Also, in the disclosure, terms including ordinal numbers such as "the first" and "the second" may be used to describe various components, but these components are not limited by the aforementioned terms. The aforementioned terms are used only for the purpose of distinguishing one component from another component. In addition, in the disclosure, terms such as "include" and "have/has" should be construed as designating that there are such characteristics, numbers, steps, operations, elements, components, or a combination thereof described in the specification, but not as excluding in advance the existence or possibility of adding one or more of other characteristics, numbers, steps, operations, elements, components, or a combination thereof. Also, the description in the disclosure that an element is "coupled with/to" or "connected to" another element should be interpreted to mean that the one element may be directly coupled with/to or connected to the another element, but still another element may exist between the elements. In contrast, the description that one element is "directly coupled" or "directly connected" to another element can be interpreted to mean that still another element does not exist between the one element and the another element. Further, in the disclosure, the expression "identical" not only means that some features perfectly coincide, but also means that the features include a difference in consideration of a machining error range. Also, in case it is determined that detailed explanation of related known functions or configurations may unnecessarily confuse the gist of the disclosure, the detailed explanation will be abridged or omitted.

Hereinafter, an embodiment of the disclosure will be described in detail with reference to the accompanying drawings, such that a person having ordinary knowledge in the technical field to which the disclosure pertains can easily carry out the embodiment. However, an embodiment of the disclosure may be implemented in several different forms, and is not limited to an embodiment of the disclosure described herein.

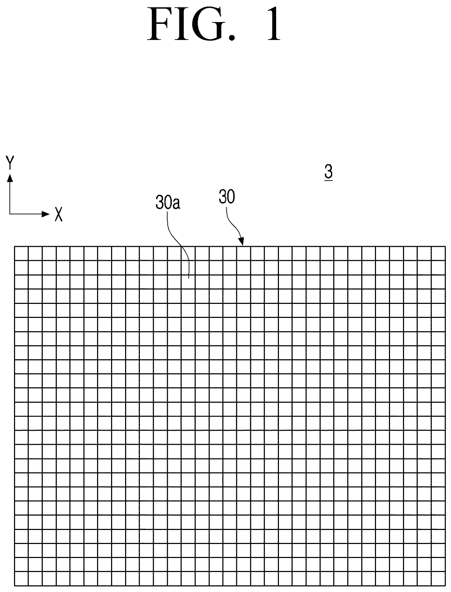

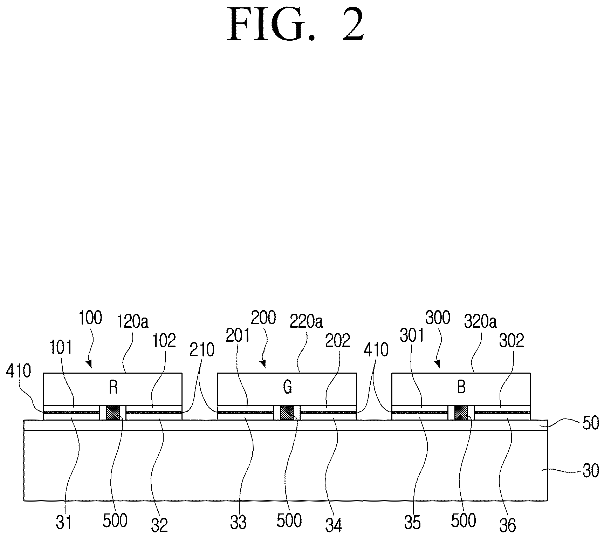

FIG. 1 is a diagram illustrating a display module according to an embodiment. FIG. 2 is a cross-sectional view illustrating a part of a display module according to an embodiment.

A display device 1 according to an embodiment may include at least one display module 3. The display device 1 may include two or more display modules 3 for providing a large screen. In this case, the two or more display modules 3 may be connected in a horizontal direction and/or a vertical direction.

Referring to FIGS. 1 and 2, the display module 3 may include a substrate 30, and a plurality of light-emitting diodes 100, 200, 300 arranged on the substrate 30. The plurality of light-emitting diodes may include a first light-emitting diode 100 emitting light of a red wavelength band, a second light-emitting diode 200 emitting light of a green wavelength band, and a third light-emitting diode 300 emitting light of a blue wavelength band.

On the substrate 30, a plurality of pixel areas 30a may be provided in an approximate grid form. To each pixel area, one pixel may be provided. One pixel may consist of a plurality of subpixels. A subpixel is one light-emitting diode.

On the substrate 30, a TFT layer 50 may be provided on the front surface of the substrate 30 on which the plurality of pixel areas 30a are provided. On the rear surface of the substrate 30, a power supply circuit that supplies power to the TFT layer 50, a data driving driver, a gate driving driver, and a timing controller that controls each driving driver may be arranged.

The TFT layer 50 may include a plurality of TFTs for driving the plurality of light-emitting diodes 100, 200, 300. The TFT layer 50 may be formed integrally on the front surface of the substrate 30, but is not limited thereto, and it may be manufactured in a form of a separate film, and attached on the front surface of the substrate 30. A plurality of substrate pads 31, 32, 33, 34, 35, 36 arranged on the TFT layer 50 may be electrically connected with the TFT layer 50.

The plurality of TFTs included in the TFT layer 50 are not limited to a specific structure or type. For example, the TFTs may be implemented as a low-temperature polycrystalline silicon (LTPS) TFT, an oxide TFT, an Si TFT (poly silicon, a-silicon), an organic TFT, a graphene TFT, etc. The TFT layer may form only a P-type (or an N-type) metal oxide semiconductor field effect transistor (MOSFET) in an Si wafer complementary metal oxide semiconductor (CMOS) process, and apply it to the substrate 30.

A plurality of contact electrodes 101, 102, 201, 202, 301, 302 provided on each of the plurality of light-emitting diodes 100, 200, 300 and the plurality of substrate pads 31, 32, 33, 34, 35, 36 of the substrate 30 may be electrically and physically connected with one another by a conductive adhesive member 410.

The plurality of light-emitting diodes 100, 200, 300 may respectively include a partition 500. The partition 500 may insulate between the plurality of contact electrodes 101, 102, 201, 202, 301, 302 of the plurality of light-emitting diodes 100, 200, 300, and between the plurality of substrate pads 31, 32, 33, 34, 35, 36 of the substrate 30. For example, the partition 500 may insulate the plurality of contact electrodes 101, 102, 201, 202, 301, 302 of each light-emitting diode 100, 200, 300 with one another, and insulate the plurality of corresponding substrate pads 31, 32, 33, 34, 35, 36 with one another.

The plurality of light-emitting diodes 100, 200, 300 may respectively include light-emitting surfaces 120a, 220a, 320a from which light is emitted. The plurality of light-emitting diodes 100, 200, 300 may be constituted in forms of flip chips wherein the plurality of contact electrodes 101, 102, 201, 202, 301, 302 are provided on the opposite sides of the light-emitting surfaces 120a, 220a, 320a.

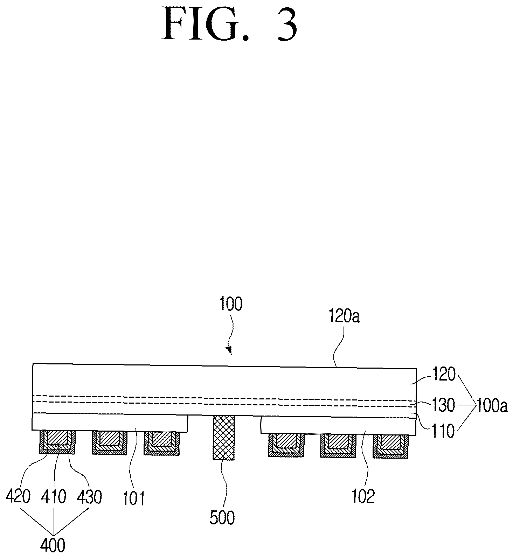

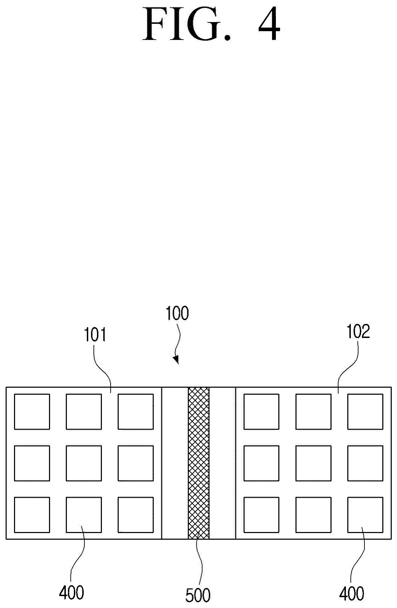

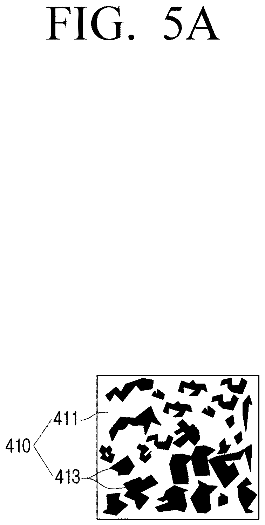

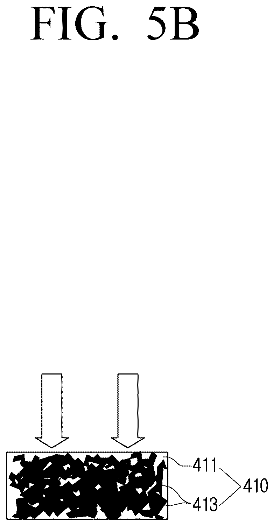

FIG. 3 is a cross-sectional view illustrating a light-emitting diode provided to a display module according to an embodiment. FIG. 4 is a bottom view illustrating a light-emitting diode provided to a display module according to an embodiment. FIG. 5A and FIG. 5B are diagrams illustrating examples wherein a conductive adhesive member provided on a light-emitting diode was modified from a state wherein electric currents cannot flow to a state wherein electric currents can flow by thermal compression according to an embodiment.

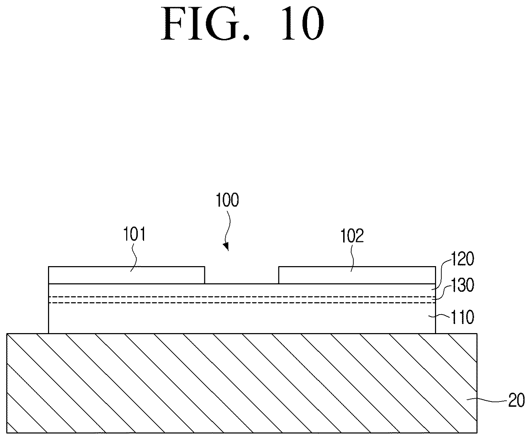

Referring to FIG. 3, the light-emitting diode 100 according to an embodiment may include a first semiconductor layer 110 and a second semiconductor layer 120 that grow on a wafer 20 (refer to FIG. 10), and an active layer 130 provided between the first semiconductor layer 110 and the second semiconductor layer 120.

The first semiconductor layer 110, the second semiconductor layer 120, and the active layer 130 may be formed by using methods such as metal organic chemical vapor deposition (MOCVD), chemical vapor deposition (CVD), plasma-enhanced chemical vapor deposition (PECVD), etc.

The first semiconductor layer 110 may include, for example, a p-type semiconductor layer. The p-type semiconductor layer may be selected, for example, from gallium nitride (GaN), aluminum nitride (AlN), aluminum gallium nitride (AlGaN), indium gallium nitride (InGaN), indium nitride (InN), indium aluminum gallium nitride (InAlGaN), aluminum indium nitride (AlInN), etc., and a p-type dopant such as magnesium (Mg), zinc (Zn), calcium (Ca), strontium (Sr), barium (Ba), etc. may be doped.

The second semiconductor layer 120 may include, for example, an n-type semiconductor layer. The n-type semiconductor layer may be selected, for example, from gallium nitride (GaN), aluminum nitride (AlN), aluminum gallium nitride (AlGaN), indium gallium nitride (InGaN), indium nitride (InN), indium aluminum gallium nitride (InAlGaN), aluminum indium nitride (AlInN), etc., and an n-type dopant such as silicon (Si), Germanium (Ge), Tin (Sn), etc. may be doped. The upper surface of the second semiconductor layer 120 may be a light-emitting surface 100a.

The light-emitting diode 100 is not limited to the aforementioned configuration. For example, in the light-emitting diode 100, the first semiconductor layer 110 may include an n-type semiconductor layer, and the second semiconductor layer 120 may include a p-type semiconductor layer.

The active layer 130 is an area wherein electrons and holes are re-coupled, and the layer transits to a lower energy level as electrons and holes are re-coupled, and may generate a light having a wavelength corresponding thereto. For example, the active layer 130 may include amorphous silicon or poly crystalline silicon. However, the active layer 130 is not limited thereto, and may include an organic semiconductor material, etc. The active layer 130 may be formed in a single quantum well (SQW) structure or a multi quantum well (MQW) structure.

The light-emitting diode 100 according to an embodiment may include a first contact electrode 101 and a second contact electrode 102. The first contact electrode 101 may be a positive electrode (an anode electrode) electrically connected to the second semiconductor layer 120. The second contact electrode 102 may be a negative electrode (a cathode electrode) electrically connected to the first semiconductor layer 110.

The light-emitting diode 100 according to an embodiment may include a plurality of conductive members 400 provided between the first contact electrode 101 and the second contact electrode 102, and a partition 500 provided between the first contact electrode 101 and the second contact electrode 102.

The plurality of conductive members 400 may be patterned in a grid form respectively on the bottom surface of the first contact electrode 101 and the bottom surface of the second contact electrode 102 as in FIG. 4. 'The bottom surfaces' of the first contact electrode 101 and the second contact electrode 102 may be surfaces that are connected to each of the first substrate pad 31 and the second substrate pad 32 respectively provided on the substrate 30 (refer to FIG. 2).

The plurality of conductive members 400 may have substantially the same structure. Accordingly, hereinafter, one conductive member 400 will be explained.

The conductive member 400 may include a conductive adhesive member 410, a first protective layer 420, and a second protective layer 430.

A curing temperature of the conductive adhesive member 410 according to an embodiment may be lower than 200°C in consideration of a limit value of a heat-resistance property. The range of a resistance value (R) after curing of the conductive adhesive member 410 may be a range from 0.1 ohm to 20 ohm. If the resistance value (R) after curing of the conductive adhesive member 410 is smaller than 0.1 ohm, material dispersibility may not be satisfied, and if the resistance value (R) after curing of the conductive adhesive member 410 exceeds 20 ohm, a current loss may be generated, and thus it is difficult to use it as the conductive adhesive member 410.

The conductive adhesive member 410 may include an epoxy resin 411 and conductive materials 413 dispersed on the epoxy resin 411 as in FIG. 5A. In case the light-emitting diode 100 transferred to a target substate is thermally compressed to the substrate 30 and cured, the epoxy resin 411 may electrically and physically connect the first substrate pad 31 and the second substrate pad 32 of the substrate 30, and the first contact electrode 101 and the second contact electrode 102 of the light-emitting diode 100 with each other.

The conductive materials 413 may be materials having high conductivity. For example, the conductive materials 413 may be gold (Au), silver (Ag), carbon (C), copper (Cu), nickel (Ni), aluminum (Al), indium (In), or tin (Sn). The conductive materials 413 may be dispersedly arranged at intervals so that they mostly do not contact each other inside the epoxy resin 411 as in FIG. 5B. The intervals between the conductive materials 413 that are pressurized at the time of thermal compression may become narrower, and the conductive materials 413 may contact each other or may be clumped, and they may get in a state wherein electric currents can flow.

The area of the conductive adhesive member 410 may be from 1% to 30% of smaller areas between the areas of the first contact electrode 101 and the second contact electrode 102 of the light-emitting diode 100 and the areas of the first substate pad 31 and the second substrate pad 32 of the substrate 30. In case the area of the conductive adhesive member 410 is smaller than 1%, smooth electrical connection between the first contact electrode 101 and the second contact electrode 102 of the light-emitting diode 100 and the first substate pad 31 and the second substrate pad 32 of the substrate 30 is difficult to be expected, and in case the area exceeds 30%, there may be a limitation on forming the plurality of conductive adhesive members 410 on the first contact electrode 101 and the second contact electrode 102 of the light-emitting diode 100 in a desired pattern.

The conductive adhesive member 410 according to an embodiment may include a flux including a plurality of fine metal grains. For example, on the conductive adhesive member 410, an adhesive resin may be arranged, and fine conductive particles may be arranged on the adhesive resin regularly or irregularly. The adhesive resin may be a thermoplastic material (e.g.: styrene butadiene, polyvinyl butylene, etc.) or a thermosetting material (an epoxy resin, polyurethane, an acrylic resin). The adhesive resin may have a blackish color so that it can absorb an external light. The external light may be a natural light or a light emitted from a lighting arranged around the display panel. The fine conductive particles may include polymer particles and a metallic material (e.g.: gold (Au), nickel (Ni), lead (Pd), etc.) wherein electric currents can flow that is coated on the surfaces of the polymer particles.

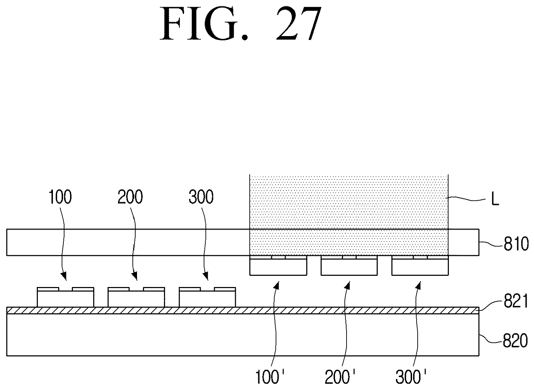

The first protective layer 420 may be formed to cover the conductive adhesive member 410 to protect the conductive adhesive member 410 at the time of a descum process. The conductive adhesive member 410 may be covered by the first protective layer 420 and may not be exposed to the outside. The descum process is an etching process of removing the second adhesive 821 (refer to FIG. 27) applied on the second carrier substrate 820 and the first protective layer 420 by using plasma.

The plurality of light-emitting diodes 100, 200, 300 are transferred from the first carrier substrate 810 to the second carrier substrate 820 before washing the second carrier substrate 820. The first protective layer 420 can improve the phenomenon wherein the conductive adhesive member 410 is partially lost or completely separated from the first contact electrodes 101, 201, 301 and the second contact electrodes 102, 202, 302 of each light-emitting diode 100, 200, 300 when washing the second carrier substrate 820 by a descum process for removing the second adhesive 821 applied on the second carrier substrate 820. The second adhesive 821 may include polydimethylsiloxane (PDMS).

The second protective layer 430 may cover the first protective layer 420 for protecting the first protective layer 420 when washing the first carrier substrate 810 by a descum process. The first protective layer 420 may be covered by the second protective layer 430 and may not be exposed to the outside.

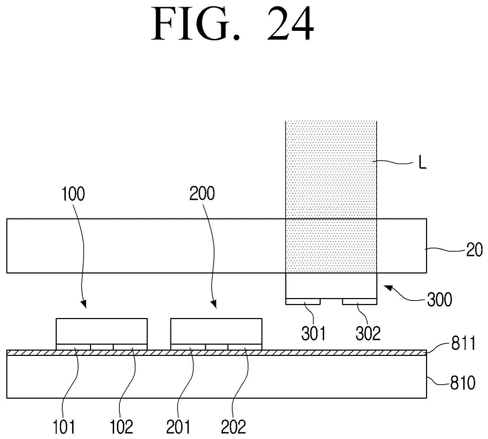

The plurality of light-emitting diodes 100, 200, 300 are transferred from the wafer 20 to the first carrier substrate 810 before washing the first carrier substrate 810. The second protective layer 430 can improve the phenomenon wherein the first protective layer 420 and the conductive adhesive member 410 are partially lost or completely separated from the first contact electrodes 101, 201, 301 and the second contact electrodes 102, 202, 302 of each light-emitting diode 100, 200, 300 when washing the first carrier substrate 810 for removing the first adhesive 811 (refer to FIG. 24) applied on the first carrier substrate 810. The first adhesive 811 may include polyimide (PI) or ultra high-cis polybutadiene rubber (NdBR).

The partition 500 may include an insulating material. The partition 500 may be provided between the first contact electrode 101 and the second contact electrode 102 for preventing or improving short between the first contact electrode 101 and the second contact electrode 102. The partition 500 may be provided on one surface of the second semiconductor layer 120 on which the first contact electrode 101 and the second contact electrode 102 are arranged.

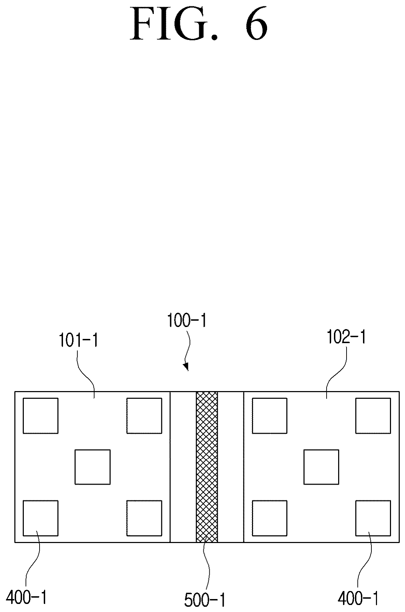

FIG. 6, 7, and 8 are bottom views illustrating a light-emitting diode according to an embodiment.

Referring to FIG. 6, a partition 500-1 may be provided between the first contact electrode 101-1 and the second contact electrode 102-1 of the light-emitting diode 100-1. The conductive members 400-1 provided on the first contact electrode 101-1 and the second contact electrode 102-1 may be patterned in various forms but not a grid form according to the sizes and the shapes.

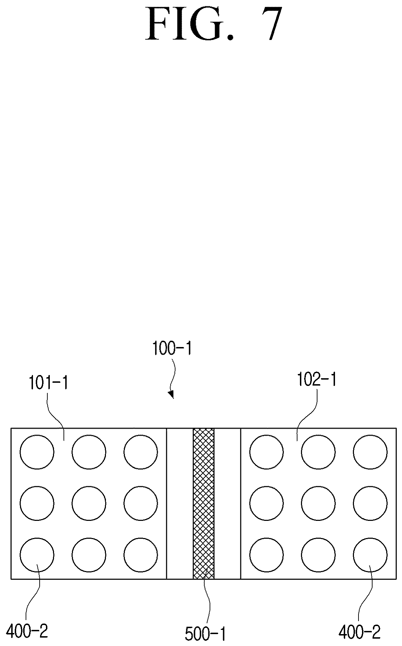

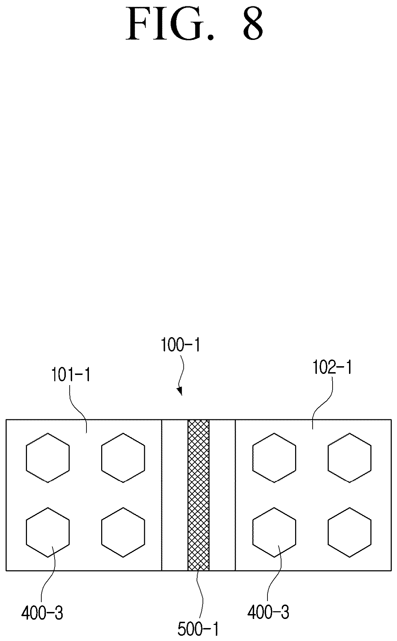

Here, the shapes of the conductive members 400-1 may be shapes that are expressed when viewing the light-emitting diode 100-1 from the bottom surface. The shapes of the conductive members 400-1 may be quadrangles as in FIG. 6. However, the shapes of the conductive members 400-1 are not limited to quadrangles, but may be constituted diversely. For example, as in FIG. 7, the shapes of the conductive members 400-2 may be constituted as circles (or ovals), and as in FIG. 8, the shapes of the conductive members 400-3 may be constituted as hexagons (or triangles, pentagons, etc.).

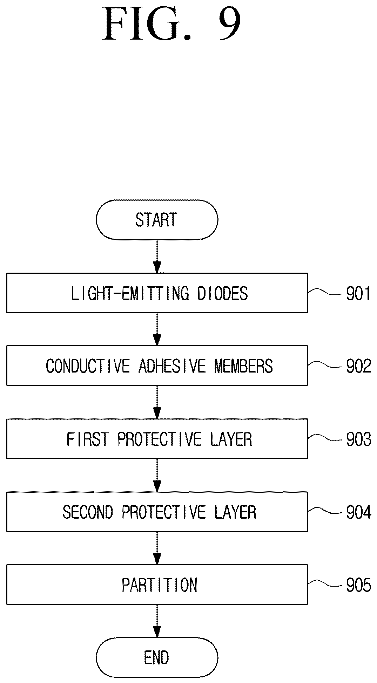

FIG. 9 is a flow chart illustrating a manufacturing process of a light-emitting diode according to an embodiment. FIG. 10 to FIG. 20 are diagrams illustrating a manufacturing process of a light-emitting diode according to an embodiment. On the wafer 20, a plurality of light-emitting diodes are formed, and for the convenience of explanation, hereinafter, a process of forming one light-emitting diode will be explained.

Referring to FIG. 10, through an epitaxial process, etc., the first semiconductor layer 110, the second semiconductor layer 120, and the active layer 130 may be formed on the wafer 20, and through a deposition process and an etching process, the first contact electrode 101 and the second contact electrode 102 may be formed on the second semiconductor layer 120 and a light-emitting diode may be formed (901 in FIG. 9).

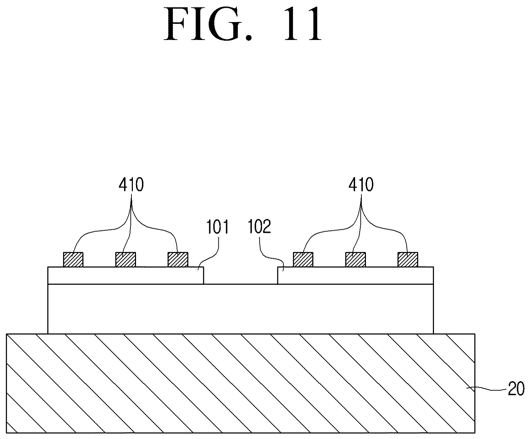

Referring to FIG. 11, a plurality of conductive adhesive members 410 are patterned on the first contact electrode 101 and the second contact electrode 102 of the light-emitting diode 100 (902 in FIG. 9).

The plurality of conductive adhesive members 410 may be formed on the first contact electrode 101 and the second contact electrode 102 of the light-emitting diode 100 through a process as follows.

For example, a conductive adhesive (not shown) is deposited on one surface 20a of the wafer 20 on which the light-emitting diode 100 is formed by specific thickness so as to cover the light-emitting diode 100. On the upper side of the wafer 20, a mask (not shown) is aligned. On the mask, a plurality of openings formed in a specific pattern may be provided so that the plurality of conductive adhesive members 410 are patterned. Through the plurality of openings of the mask, ultraviolet (UV) is irradiated on the conductive adhesive. After UV irradiation is completed, a partial area of the conductive adhesive wherein patterning is not necessary (e.g., an area not corresponding to the first contact electrode 101 and the second contact electrode 102 of the light-emitting diode 100) is removed by the etching process. Accordingly, the plurality of conductive adhesive members 410 may be patterned on the first contact electrode 101 and the second contact electrode 102 of the light-emitting diode 100.

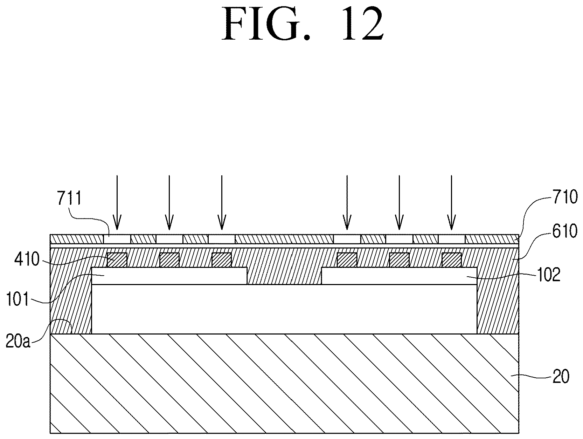

Referring to FIG. 12, a first photoresist (PR) layer 610 is deposited by specific thickness on one surface 20a of the wafer 20 so as to cover the light-emitting diode 100 and the plurality of conductive adhesive members 410 together.

A first mask 710 is aligned on the first PR layer 610. On the first mask 710, a plurality of first openings 711 corresponding to the size of the first protective layer 420 may be provided. The plurality of first openings 711 may be provided on the first mask 710 so as to correspond to each of the plurality of conductive adhesive members 410. The sizes of the first openings 711 may be bigger than the sizes of the conductive adhesive members 410.

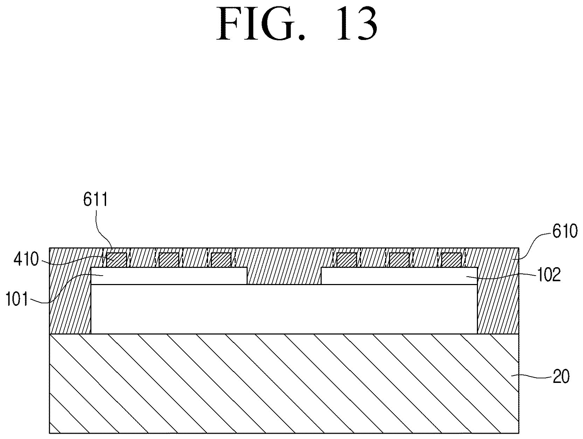

UV is irradiated on the first PR layer 610 through the plurality of first openings 711 of the first mask 710. The partial area 611 of the first PR layer 610 on which UV was irradiated is cured as in FIG. 13.

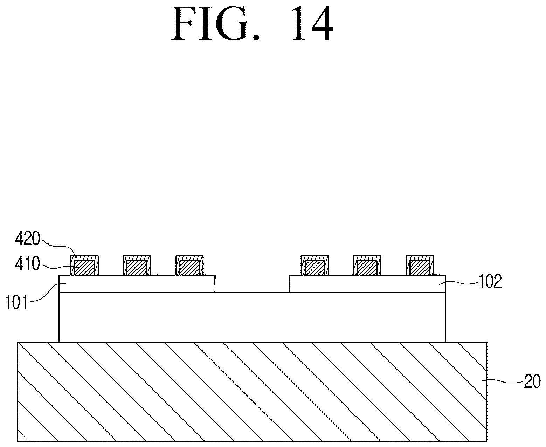

Referring to FIG. 14, the first PR layer 610 excluding the cured partial area 611 in the first PR layer 610 is removed on the wafer 20 by an etching process. Accordingly, a plurality of first protective layers 420 covering the plurality of conductive adhesive members 410 may be formed on the first contact electrode 101 and the second contact electrode 102 of the light-emitting diode 100 (903 in FIG. 9).

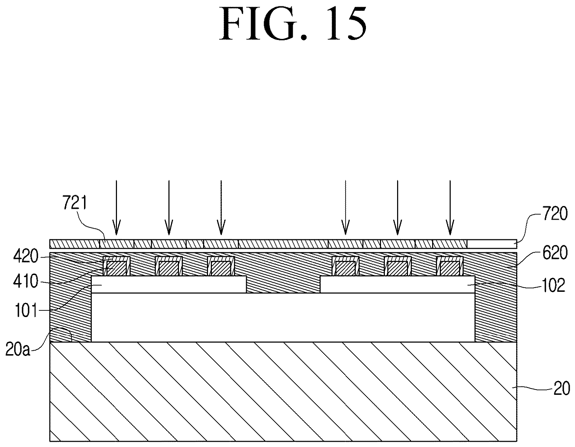

Referring to FIG. 15, a second PR layer 620 is deposited by specific thickness on one surface 20a of the wafer 20 so as to cover the light-emitting diode 100 and the plurality of first protective layers 420 together.

A second mask 720 is aligned on the second PR layer 620. On the second mask 720, a plurality of second openings 721 corresponding to the size of the second protective layer 430 may be provided. The plurality of second openings 721 may be provided on the second mask 720 so as to correspond to each of the plurality of first protective layers 420. The sizes of the second openings 721 may be bigger than the sizes of the first protective layers 420.

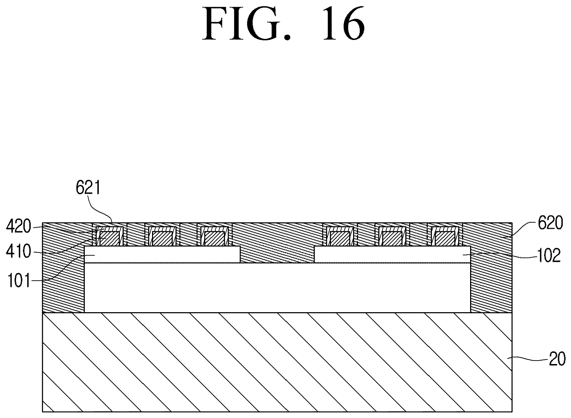

UV is irradiated on the second PR layer 620 through the plurality of second openings 721 of the second mask 720. The partial area 621 of the second PR layer 620 on which UV was irradiated is cured as in FIG. 16.

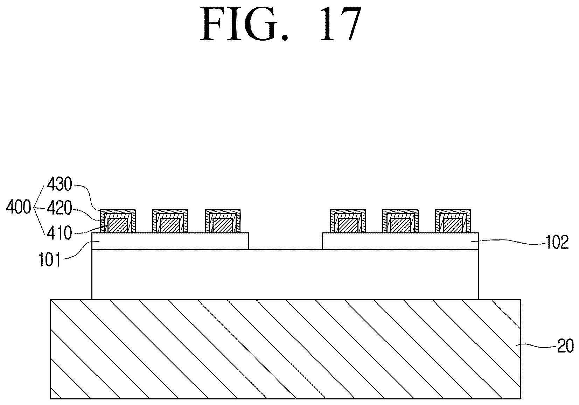

Referring to FIG. 17, the second PR layer 620 excluding the cured partial area 621 in the second PR layer 620 is removed on the wafer 20 by an etching process. Accordingly, a plurality of second protective layers 430 covering the plurality of first protective layers 420 may be formed on the first contact electrode 101 and the second contact electrode 102 of the light-emitting diode 100 (904 in FIG. 9).

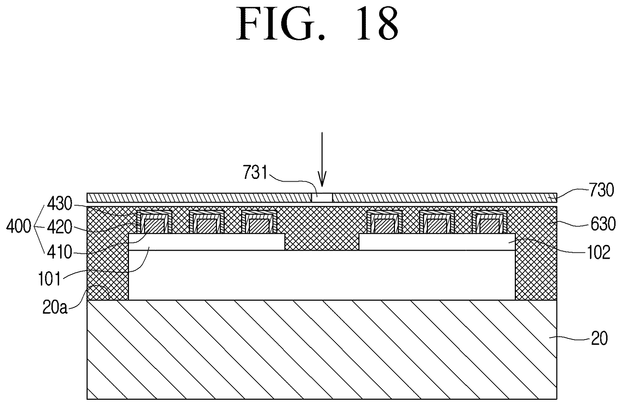

Referring to FIG. 18, a third PR layer 630 is deposited by specific thickness on one surface 20a of the wafer 20 so as to cover the light-emitting diode 100 and the plurality of second protective layers 430 together.

A third mask 730 is aligned on the third PR layer 630. On the third mask 730, a third opening 731 may be provided in a location wherein the partition 500 will be formed. The third opening 731 may be located between the first contact electrode 101 and the second contact electrode 102 of the light-emitting diode 100.

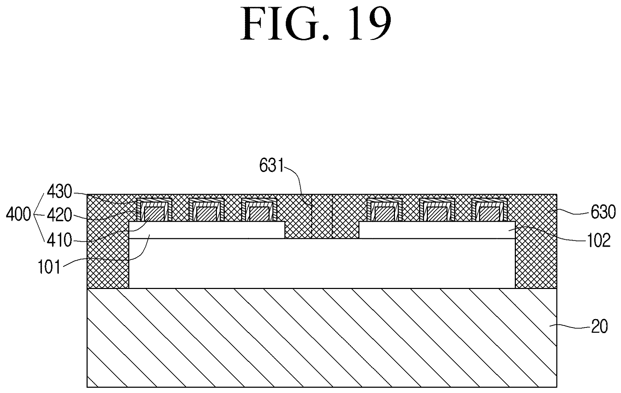

UV is irradiated on the third PR layer 630 through the third opening 731 of the third mask 730. The partial area 631 of the third PR layer 630 on which UV was irradiated is cured as in FIG. 19.

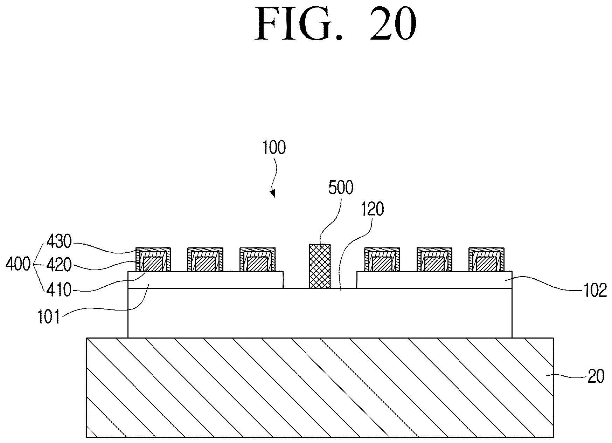

Referring to FIG. 20, the third PR layer 630 excluding the cured partial area 631 in the third PR layer 630 is removed on the wafer 20 by an etching process. Accordingly, the partition 500 may be formed between the first contact electrode 101 and the second contact electrode 102 of the light-emitting diode 100 (905 in FIG. 9). The partition 500 may be formed on one surface of the second semiconductor layer 120.

The conductive adhesive members 410, the first protective layer 420, the second protective layer 430, and the partition 500 provided to the light-emitting diode according to an embodiment are not limited to the aforementioned manufacturing process, and may be applied on a predetermined location by an application method using silk screen, an inkjet method, or a dispensing method, and then go through a curing process. For example, after applying the conductive adhesive members 410 on the first contact electrode 101 and the second contact electrode 102 of the light-emitting diode 100, the conductive adhesive members 410 may be cured by irradiating UV. After applying the second protective layer 430 so as to cover the first protective layer 420, the second protective layer 430 may be cured by irradiating UV.

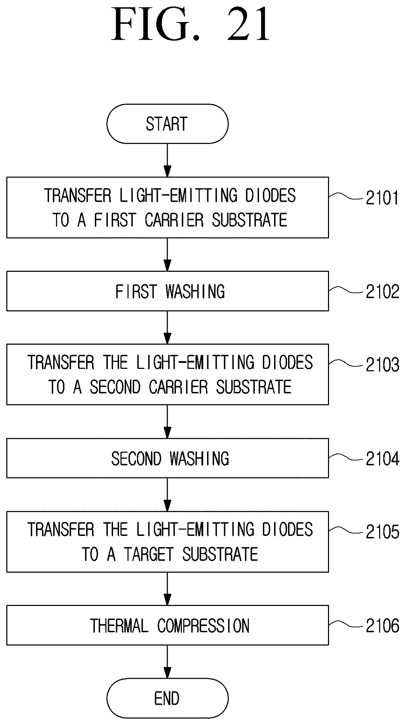

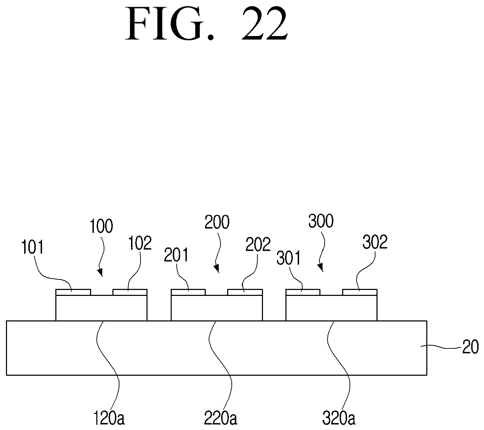

FIG. 21 is a flow chart illustrating a manufacturing process of a display module according to an embodiment. FIG. 22 to FIG. 32 are diagrams illustrating a manufacturing process of a display module according to an embodiment.

Referring to FIG. 22, the plurality of light-emitting diodes (the first, second, and third light-emitting diodes 100, 200, 300) may be formed to grow on the wafer 20. On each light-emitting diode, the first contact electrodes 101, 201, 301 and the second contact electrodes 102, 202, 302 may be formed on opposite surfaces of the light-emitting surfaces 120a, 220a, 320a respectively.

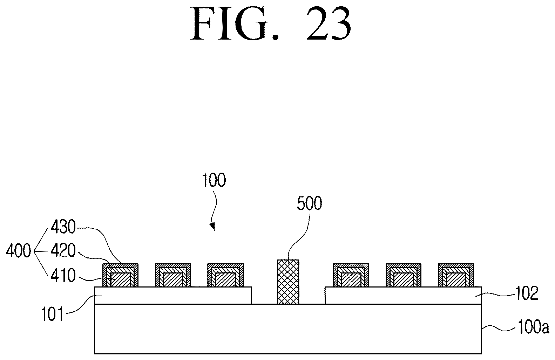

Referring to FIG. 23, in the first light-emitting diode 100, a plurality of conductive members 400 may be provided on each of the first contact electrode 101 and the second contact electrode 102. In this case, each conductive member 400 includes a conductive adhesive member 410, a first protective layer 420 covering the conductive adhesive member 410, and a second protective layer 430 covering the first protective layer 420. The second and third light-emitting diodes 200, 300 may include substantially the same components as the first light-emitting diode 100.

Referring to FIG. 24, the plurality of light-emitting diodes 100, 200, 300 may be transferred from the wafer 20 to the first carrier substrate 810 (2101 in FIG. 21).

The plurality of light-emitting diodes 100, 200, 300 may be transferred to the first carrier substrate 810 by a laser beam L irradiated on the wafer 20. The first contact electrodes 101, 201, 301 and the second contact electrodes 102, 202, 302 of the plurality of light-emitting diodes 100, 200, 300 may be attached to the first carrier substrate 810 by a first adhesive 811 applied on the upper surface of the first carrier substrate 810.

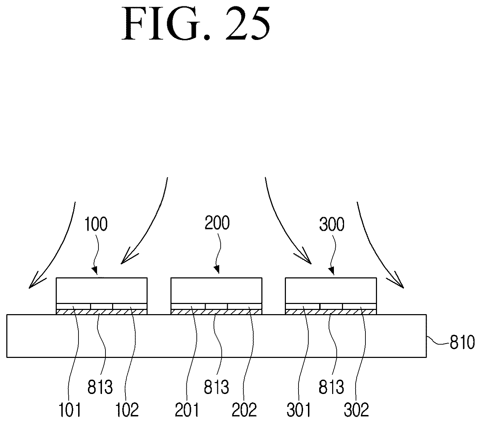

Referring to FIG. 25, most of the first adhesive 811 on the first carrier substrate 810 may be removed by the first washing (e.g., a descum process) (2102 in FIG. 21).

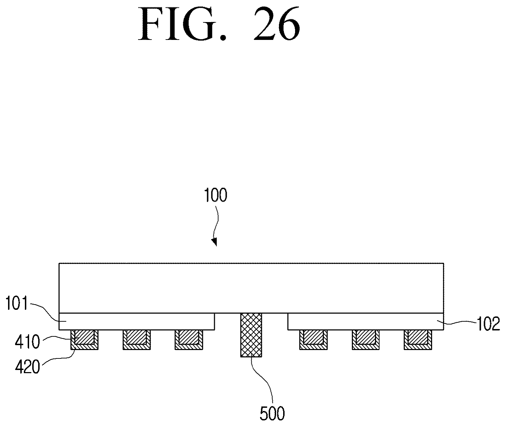

When washing the first carrier substrate 810, all of the second protective layer 430 may be removed from the first protective layer 420 as in FIG. 26. Alternatively, most of the second protective layer 430 excluding a part of the second protective layer 430 that remains around the first protective layer 420 may be removed from the first protective layer 420 when washing the first carrier substrate 810.

Referring to FIG. 27, the plurality of light-emitting diodes 100, 200, 300, 100', 200', 300' may be transferred from the first carrier substrate 810 to the second carrier substrate 820 (2103 in FIG. 21).

The plurality of light-emitting diodes 100, 200, 300, 100', 200', 300' may be transferred to the second carrier substrate 820 by a laser beam L irradiated on the first carrier substrate 810. According to the size of a spot of the laser beam L focused on the first carrier substrate 810, light-emitting diodes of a specific number may be simultaneously transferred to the second carrier substrate 820 as in FIG. 27.

The light-emitting surfaces of the plurality of light-emitting diodes 100, 200, 300, 100', 200', 300' may be attached to the second carrier substrate 820 by a second adhesive 821 applied on the upper surface of the second carrier substrate 820.

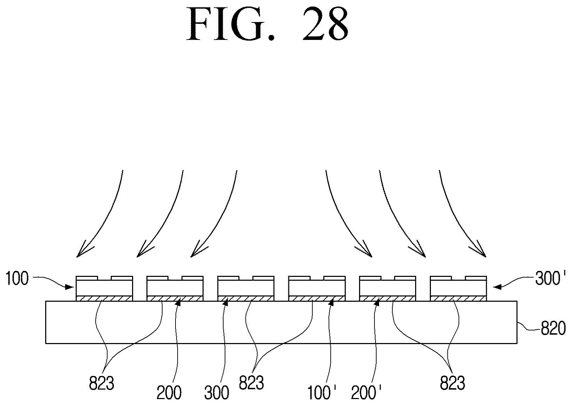

Referring to FIG. 28, most of the second adhesive 821 on the second carrier substrate 820 may be removed by the first washing (e.g., a descum process) (2104 in FIG. 21).

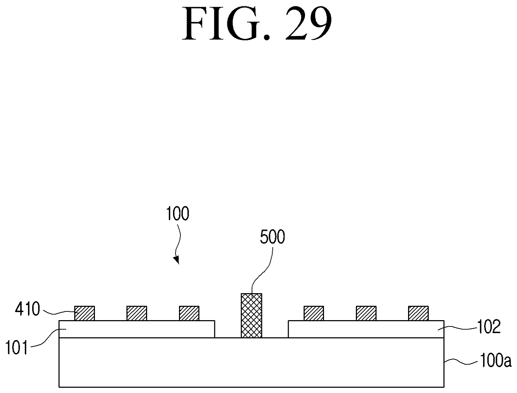

When washing the second carrier substrate 820, all of the first protective layer 420 may be removed from the conductive adhesive members 410 as in FIG. 29. Alternatively, most of the first protective layer 420 excluding a part of the first protective layer 420 that remains around the conductive adhesive members 410 may be removed from the conductive adhesive members 410 when washing the second carrier substrate 820.

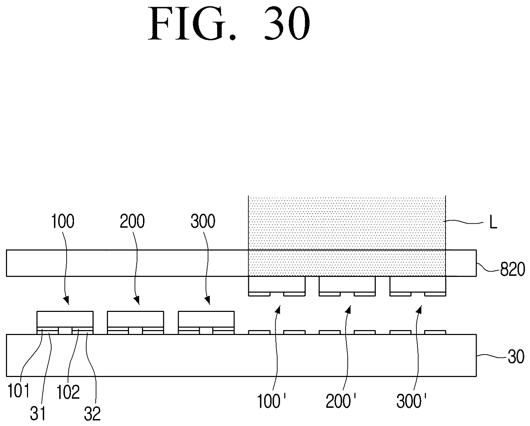

Referring to FIG. 30, the plurality of light-emitting diodes 100, 200, 300, 100', 200', 300' may be transferred from the second carrier substrate 820 to the substrate 30 which is the target substrate (2105 in FIG. 21). The substrate 30 is included in the display module 3. The plurality of light-emitting diodes 100, 200, 300, 100', 200', 300' may be transferred to the substrate 30 by a laser beam L irradiated on the second carrier substrate 820.

The first contact electrodes and the second contact electrodes of the plurality of light-emitting diodes 100, 200, 300, 100', 200', 300' may be seated on the corresponding first substrate pads and the corresponding second substrate pads of the substrate 30. For example, as in FIG. 30, the first contact electrode 101 of the first light-emitting diode 100 may be seated on the first substrate pad 31 of the substrate 30, and the second contact electrode 102 of the first light-emitting diode 100 may be seated on the second substrate pad 32 of the substrate 30. The plurality of conductive adhesive members 410 may be located between the first contact electrode 101 and the first substrate pad 31, and between the second contact electrode 102 and the second substrate pad 32.

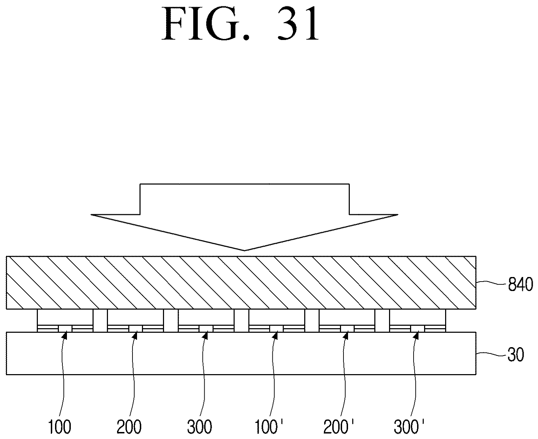

Referring to FIG. 31, the plurality of light-emitting diodes 100, 200, 300, 100', 200', 300' may be thermally compressed to the substrate 30 by a pressurizing member 840 (2106 in FIG. 21).

The plurality of conductive adhesive members 410 may be welded between the first contact electrodes of the plurality of light-emitting diodes 100, 200, 300, 100', 200', 300' and the corresponding first substrate pads of the substrate 30, and between the second contact electrodes of the plurality of light-emitting diodes 100, 200, 300, 100', 200', 300' and the corresponding second substrate pads of the substrate 30. Accordingly, the first contact electrodes of the plurality of light-emitting diodes 100, 200, 300, 100', 200', 300' and the corresponding first substrate pads of the substrate 30 may be electrically and physically connected with each other. The second contact electrodes of the plurality of light-emitting diodes 100, 200, 300, 100', 200', 300' and the corresponding second substrate pads of the substrate 30 may be electrically and physically connected with each other.

When the plurality of light-emitting diodes 100, 200, 300, 100', 200', 300' are thermally compressed to the side of the substrate 30 by the pressurizing member 840, the intervals between the conductive materials 413 included in the plurality of conductive adhesive members 410 may become narrower, and the conductive materials 413 may contact each other or may be clumped, and they may get in a state wherein electric currents can flow (refer to FIG. 5B).

The plurality of conductive adhesive members 410 of the partition 500 may be pressurized to the direction of thermal compression between the first contact electrodes and the second contact electrodes of the plurality of light-emitting diodes 100, 200, 300, 100', 200', 300'. The partition 500 may prevent or improve the phenomenon wherein the first contact electrodes and the second contact electrodes of the plurality of light-emitting diodes 100, 200, 300, 100', 200', 300' are shorted by the conductive adhesive members 410 that are pressurized at the time of thermal compression.

The display module 3 according to an embodiment may include a plurality of conductive members 400 patterned on the first contact electrodes and the second contact electrodes of each light-emitting diode 100, 200, 300, 100', 200', 300'. Each conductive member 400 may include conductive adhesive members 410, and a first protective layer 420 covering the plurality of conductive adhesive members 410 and a second protective layer 430 covering the first protective layer 420 for preventing loss of the conductive adhesive members 410 when washing the substrate 30. The first protective layer 420 and the second protective layer 430 make the conductive adhesive members 410 maintained on the first contact electrodes and the second contact electrodes until the plurality of light-emitting diodes 100, 200, 300, 100', 200', 300' are transferred to the substrate 30 through a plurality of processes after being formed on the wafer 20.

The display module 3 according to an embodiment may be electrically and physically connected to the substrate 30 by the plurality of conductive adhesive members 410 provided to the plurality of light-emitting diodes 100, 200, 300, 100', 200', 300'. Accordingly, when manufacturing the display module 3, a process of coating a specific adhesive on an entire surface of the substrate 30 for electrically and physically connecting the plurality of light-emitting diodes 100, 200, 300, 100', 200', 300' to the substrate 30 may be omitted, and thus the material cost can be saved.

Meanwhile, a method of manufacturing a display module according to an embodiment may include the steps of transferring the plurality of light-emitting diodes of the substrate 30 to the first carrier substrate 810, and transporting the light-emitting diodes from the first carrier substrate 810 to the substrate 30. In this case, in the conductive member 400 provided on each light-emitting diode, the second protective layer 430 may be omitted, and thus the conductive member 400 may include the conductive adhesive member 410 and the first protective layer 420. In this regard, the method of manufacturing the light-emitting diode 100 may include the step of forming a partition 500 between the first contact electrode 101 and the second contact electrode 102 of the light-emitting diode 100 subsequently to the step of forming the first protective layer 420 covering the conductive adhesive member 410.

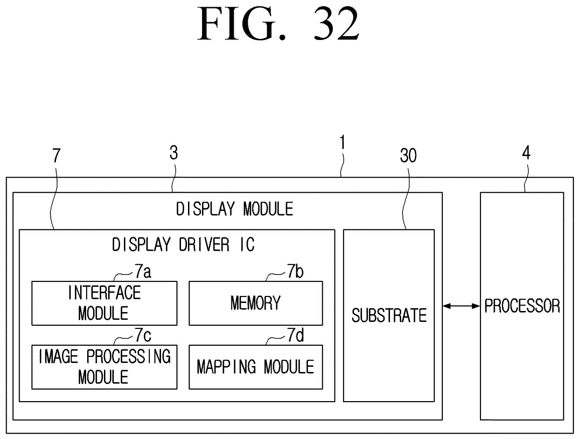

FIG. 32 is a block diagram illustrating a display device according to an embodiment.

Referring to FIG. 32, a display device 1 may include a display module 3 and a processor 4. The display module 3 may include a substrate 30, and a display driver integrated circuit (IC) 7 for controlling driving of a plurality of light-emitting diodes 100, 200, 300 provided to the substrate 30.

The processor 4 may be implemented as a digital signal processor (DSP) processing digital image signals, a microprocessor, a graphics processing unit (GPU), an artificial intelligence (AI) processor, a neural processing unit (NPU), and a time controller (TCON). However, the disclosure is not limited thereto, and the processor 4 may include one or more of a central processing unit (CPU), a micro controller unit (MCU), a micro processing unit (MPU), a controller, an application processor (AP) or a communication processor (CP), and an ARM processor, or may be defined by the terms. Also, the processor 4 may be implemented as a system on chip (SoC) having a processing algorithm stored therein or large scale integration (LSI), or implemented in forms of an application specific integrated circuit (ASIC) and a field programmable gate array (FPGA).

The processor 4 may control hardware or software components connected to the processor 4 by driving an operating system or an application program, and perform various types of data processing and operations. Also, the processor 4 may load instructions or data received from at least one of other components on volatile memory and process them, and store various data in non-volatile memory.

The display driver IC may include an interface module 7a, memory 7b (e.g.: buffer memory), an image processing module 7c, or a mapping module 7d. The display driver IC 7 may receive, for example, image data or image information including an image control signal corresponding to an instruction for controlling the image data from another component of the display device 1 through the interface module 7a. For example, according to an embodiment, the image information may be received from the processor 4 (e.g.: a main processor (e.g.: an application processor)) or a subsidiary processor (e.g.: a graphics processing unit) independently operated from the function of the main processor.

The display driver IC 7 may communicate with a sensor module through the interface module 7a. Also, the display driver IC 7 may store at least some of the received image information in the memory 7b, for example, in frame units. The image processing module 7c may, for example, perform pre-processing or post-processing (e.g.: adjustment of the resolution, the brightness, or the size) of at least a part of the image data based at least partially on the characteristic of the image data or the characteristic of the substrate 30. The mapping module 7d may generate a voltage value or a current value corresponding to the image data that was pre-processed or post-processed through the image processing module 7c. According to an embodiment, generation of a voltage value or a current value may, for example, performed based at least partially on the attributes of the pixels of the substrate 30 (e.g.: the arrangement of the pixels (an RGB stripe or a pentile structure), or the sizes of each of the subpixels). At least some pixels of the substrate 30 are driven, for example, based at least partially on the voltage value or the current value, and accordingly, visual information corresponding to the image data (e.g.: texts, images, or icons) may be displayed through the substrate 30.

The display driver IC 7 may transmit a driving signal (e.g.: a driver driving signal, a gate driving signal, etc.) to the display based on the image information received from the processor 4.

The display driver IC 7 may display an image based on an image signal received from the processor 4. As an example, the display driver IC 7 may generate a driving signal of a plurality of subpixels based on an image signal received from the processor 4, and display an image by controlling light emission of the plurality of subpixels based on the driving signal.

According to an embodiment, the display module 3 may further include a touch circuit. The touch circuit may include a touch sensor and a touch sensor IC for controlling it. The touch sensor IC may, for example, control the touch sensor for detecting a touch input or a hovering input for a designated location of the substrate 30. For example, the touch sensor IC may detect a touch input or a hovering input by measuring a change of a signal (e.g.: a voltage, a light amount, a resistance, or a charge amount) for a designated location of the substrate 30. The touch sensor IC may provide information about the detected touch input or hovering input (e.g.: the location, the area, the pressure, or the time) to the processor 4. According to an embodiment, at least a part of the touch circuit (e.g.: the touch sensor IC) may be included as a part of the display driver IC 7, or the substrate 30, or a part of another component arranged on the outside of the display module 3 (e.g.: the subsidiary processor).

According to an embodiment, the pixel driving method of the display module 3 may be an active matrix (AM) driving method or a passive matrix (PM) driving method.

According to an embodiment, the display device 1 may include the display module 3. The display module 3 may display various images. Here, an image may include a still image and/or a moving image. The display module 3 may display various images such as a broadcasting content, a multimedia content, etc. Also, the display module 3 may display a user interface and icons.

According to an embodiment, the display module 3 may be applied by being installed on a wearable device, a portable device, a handheld device, and electronic products or electronic components which need various types of displays.

According to an embodiment, the display device 1 may include a plurality of display modules 3. The plurality of display modules 3 may be physically connected and implement a large size display (e.g., a large format display). The large size display may be a monitor for a personal computer, a high resolution television, signage (or, digital signage), or an electronic display wherein a plurality of display modules are arranged in a grid arrangement.

While the disclosure has been illustrated and described with reference to various embodiments above, a person having ordinary knowledge in the technical field to which the disclosure belongs would be able to understand that various modifications may be made in the forms and the details, without departing from the idea and the scope defined by the appended claims and the equivalents thereof.

## Claims

1. A light-emitting diode comprising:
a first semiconductor layer;
a second semiconductor layer;
an active layer between the first semiconductor layer and the second semiconductor layer, the active layer being configured to emit light;
a first contact electrode to be electrically connected with the second semiconductor layer;
a second contact electrode to be electrically connected with the first semiconductor layer; and
a plurality of conductive members on the first contact electrode and the second contact electrode,
wherein the plurality of conductive members respectively comprise:
a conductive adhesive member; and
a first protective layer that covers the conductive adhesive member.

2. The light-emitting diode of claim 1,
wherein the protective layer is a first protective layer, and
the plurality of conductive members further respectively comprise:
a second protective layer that covers the first protective layer.

3. The light-emitting diode of claim 1, further comprising:
a partition between the first contact electrode and the second contact electrode and includes an insulating material.

4. The light-emitting diode of claim 1,
wherein the plurality of conductive members are arranged on the first contact electrode and the second contact electrode at intervals.

5. The light-emitting diode of claim 1,
wherein the plurality of conductive members are arranged on the first contact electrode and the second contact electrode in specific patterns.

6. The light-emitting diode of claim 1,
wherein the plurality of conductive members have a polygonal shape, a circular shape, or an oval shape when the light-emitting diode is viewed from a bottom surface.

7. The light-emitting diode of claim 1,
wherein a curing temperature of the conductive adhesive member is lower than 200°C.

8. The light-emitting diode of claim 1,
wherein a range of resistance values after curing of the conductive adhesive member is from 0.1 ohm to 20 ohm.

9. The light-emitting diode of claim 1,
wherein the conductive adhesive member comprises:
an epoxy resin; and
conductive materials dispersed on the epoxy resin at intervals, and
wherein the intervals between the conductive materials narrow when the light-emitting diode is thermally pressed to the substrate, the conductive materials contacting each other or being clumped, the conductive materials making electric currents flow between the first contact electrode and a first substrate pad of the substrate and between the second contact electrode and a second substrate pad of the substrate.

10. The light-emitting diode of claim 9,
wherein areas of each of the conductive adhesive members are from 1% to 30% of smaller areas between the areas of the first contact electrode and the second contact electrode and the areas of the first substate pad and the second substrate pad.

11. The light-emitting diode of claim 1,
wherein the light-emitting diode is one of a plurality of light-emitting diodes, the plurality of light-emitting diodes being constituted in forms of flip chips.

12. A method of manufacturing a light-emitting diode, the method comprising:
patterning a plurality of conductive adhesive members on a first contact electrode and a second contact electrode of the light-emitting diode formed on a wafer; and
forming a plurality of protective layers so as to cover the plurality of conductive adhesive members, respectively.

13. The method of manufacturing the light-emitting diode of claim 12, further comprising:
forming a partition including an insulating material between the first contact electrode and the second contact electrode of the light-emitting diode.

14. The method of manufacturing the light-emitting diode of claim 12, further comprising:
forming a plurality of second protective layers so as to cover the plurality of protective layers, respectively.

15. A display module comprising:
a substrate having a surface;
a plurality of substrate pads arranged on the surface of the substrate; and
a plurality of light-emitting diodes including a plurality of contact electrodes connected to the plurality of substrate pads,
wherein the plurality of light-emitting diodes respectively comprise:
a conductive connection member that electrically and physically connects the plurality of substrate pads and the plurality of contact electrodes; and
a plurality of walls between the plurality of contact electrodes insulate the plurality of contact electrodes.
